Europäisches Patentamt

(19) European Patent Office

Office européen des brevets

(11) Publication number: **0 039 160**
A2

# (12) EUROPEAN PATENT APPLICATION

(21) Application number: **81301598.9**

(22) Date of filing: **10.04.81**

(51) Int. Cl.³: **H 05 K 1/11**
**H 05 K 3/34, H 01 L 21/88**

(30) Priority: **29.04.80 US 145215**

(43) Date of publication of application:
**04.11.81 Bulletin 81/44**

(84) Designated Contracting States:
**CH DE FR GB IT LI NL**

(71) Applicant: **MINNESOTA MINING AND MANUFACTURING COMPANY**
**3M Center, P.O. Box 33427**
**St. Paul, MN 55133(US)**

(72) Inventor: **Baker, Dennis L.**
**2501 Hudson Road P.O. Box 33427**
**St. Paul Minnesota 55133(US)**

(72) Inventor: **Toner, Michael E.**
**2501 Hudson Road P.O. Box 33427**
**St. Paul Minnesota 55133(US)**

(74) Representative: **Baillie, Iain Cameron et al,**
**c/o Ladas & Parry Blumenstrasse 48**
**D-8000 München 2(DE)**

(54) Methods for bonding conductive bumps to electronic circuitry.

(57) Methods for bonding conductive bumps to conductive elements of electronic circuitry are described. Employment of conductive bumps reduces the possibility of electrical shorting which may occur whenever circuitries are brought into close proximity with one another. Bonding is accomplished by providing a substrate (11) having thereon a plurality of conductive bumps (15) arranged in a predetermined pattern; aligning the electronic circuitry adjacent the substrate (11) such that the conductive elements, illustrated here as leads (40), contact the conductive bumps (15); bonding the conductive bumps (15) to the leads (40); and separating the electronic circuitry from substrate (11). In this manner, a plurality of conductive bumps can be bonded to the conductive elements of electronic circuitry in one operation. These methods avoid the need for costly and extensive masking of the minute conductive elements, conserve precious metals and provide means for fabricating conductive bumps having contoured surfaces.

./...

Croydon Printing Company Ltd.

FIG. 4A

FIG. 4C

## METHODS FOR BONDING CONDUCTIVE
## BUMPS TO ELECTRONIC CIRCUITRY

### Technical Field

This invention relates to methods for bonding conductive bumps to conductive elements of electronic circuitry.

### Background Art

Employment of beam tape as an interconnect for a semiconductor device is desirable since gang bonding techniques (i.e., techniques whereby there is simultaneous formation of multiple bonds in one operation) may be conveniently employed to electrically interconnect the numerous conductive elements of these two circuitries.

Employment of beam tape as an interconnect for a semiconductor device typically requires that either the leads of the beam tape or the contact pads of the semiconductor device be provided with raised conductive bumps (i.e., be "bumped"). The use of raised bumps is desirable in order to reduce the possibility of electrical shorting which may occur whenever circuitries are brought into close proximity with one another such as in subsequent packaging operations and during ultimate use of the circuitries.

In the past, the common practice has been to employ bumped semiconductor devices when using beam tape as an interconnect. However, bumped semiconductor devices are expensive and are limited in terms of availability. It has only recently been suggested to employ bumped beam tape (i.e., beam tape in which the leads have been provided with conductive bumps) in order to circumvent the expense and limited availability of bumped semiconductor devices.

Bumped beam tape generally has been fabricated using both conventional additive metallization and subtractive metallization techniques performed directly on the leads themselves, e.g. such as described in U.S. Patent Nos 3,832,769 (Olyphant et al.) and 3,440,027 (Hugle), respectively. Additive metallization techniques are generally preferred over substractive metallization techniques since additive metallization techniques can offer greater conservation of precious metals. In achieving that greater conservation of precious metals, however, additive metallization techniques typically require extensive masking of the leads in order to permit placement of the metallization precisely where it is needed on the leads. Unfortunately, such masking can be an expensive and laborious process when performed on the minute leads of beam tape. A further limitation of additive metallization techniques when performed directly on the leads themselves is that certain desirable bump geometrics (e.g., bumps having contoured bonding surfaces) are only obtained with great inconvenience.

## Disclosure of Invention

The present invention provides a novel method for bonding a plurality of conductive bumps to the conductive elements of electronic circuitry (e.g., to leads of beam tape or to contact pads of semiconductor devices), the method comprising the steps of:

    (a)   providing a substrate having thereon a plurality of conductive bumps arranged in a predetermined pattern,

    (b)   aligning said electronic circuitry adjacent said substrate such that said conductive elements of said electronic circuitry contact said conductive bumps,

(c)  bonding said conductive bumps to said
conductive elements of said electronic
circuitry, and

(d)  separating said electronic circuitry having
said conductive bumps bonded thereto from said
substrate.

The methods of the present invention provide a
convenient means for bonding conductive bumps to the
conductive elements of beam tape or semiconductor devices,
thereby permitting subsequent packaging of the circuitries
in a manner which avoids undesirable electrical shorting.
These methods avoid the need for costly and extensive
masking of the minute conductive elements and at the same
time, conserve precious metals since the metal is placed
precisely where it is needed on the conductive element.
In addition, the methods of the present invention provide
means for fabricating bumped beam tape or bumped
semiconductor devices having bumps of geometries (e.g.,
contoured surfaces) which are not easily obtained with the
conventional methods.

## Brief Description of Drawings

The invention will be described in more detail
hereinafter with reference to the accompanying drawing
wherein like reference characters refer to the same parts
throughout the several views and in which:

FIGS. 1A-1E are cross-sectional views
illustrating sequential steps in the preparation of
conductive bumps in accordance with the present
invention;

FIGS. 2A-2E are cross-sectional views
illustrating sequential steps analogous to those of
FIGS. 1A-1E, but wherein an alternative substrate is
employed;

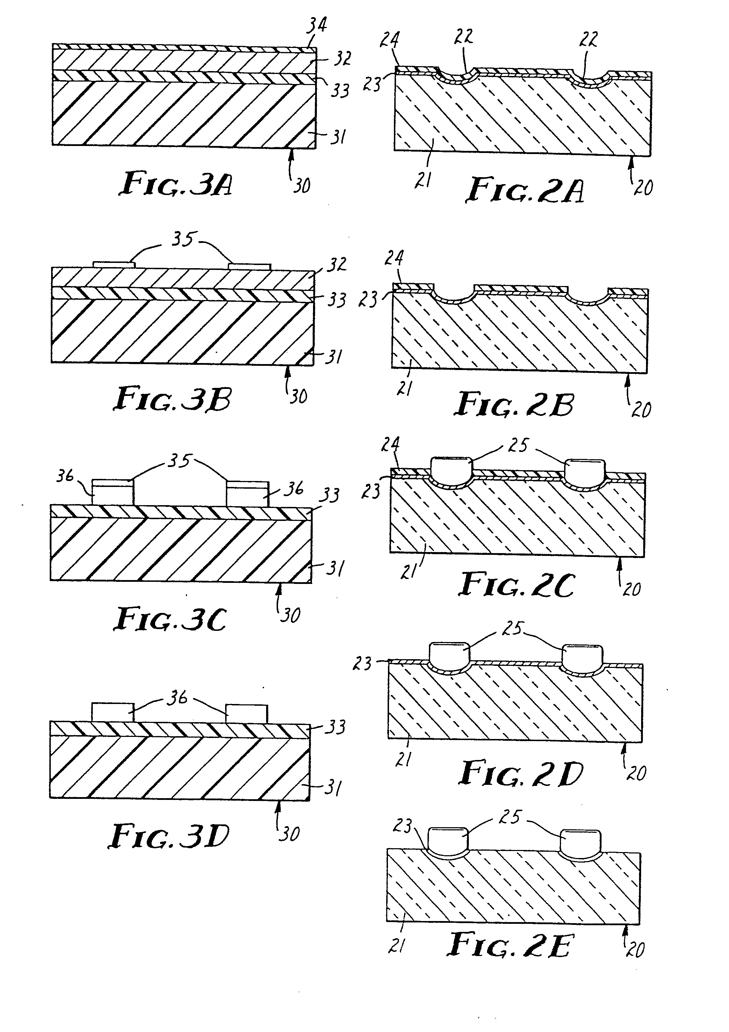

FIGS. 3A-3D are cross-sectional views
illustrating alternative sequential steps in the preparation of conductive bumps in accordance with the present invention;

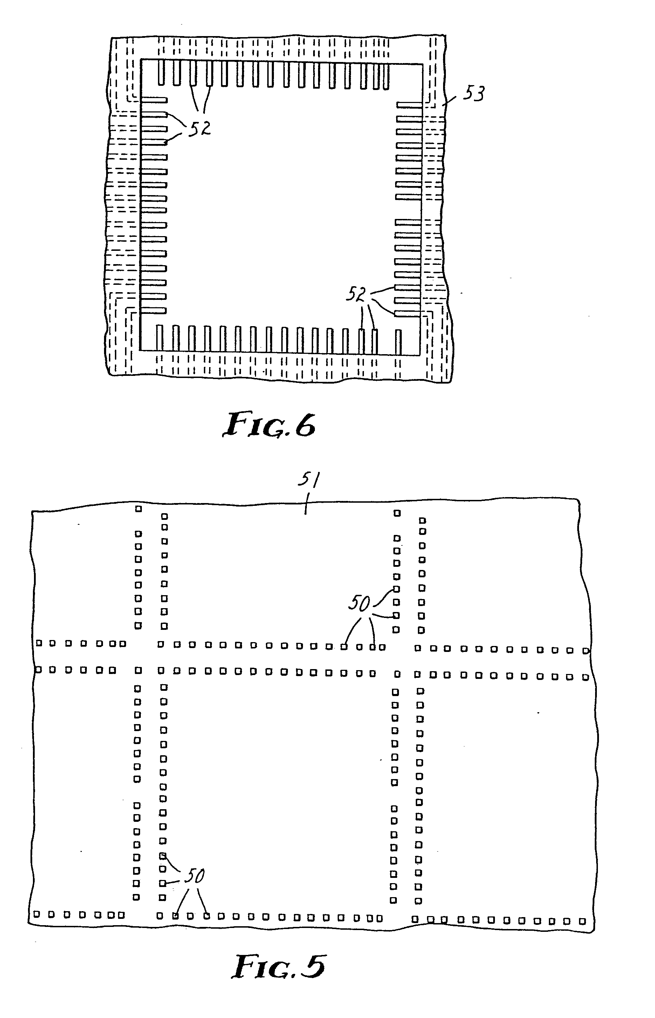

FIG. 4A-4C are cross-sectional views illustrating sequential steps in the bonding of conductive bumps to conductive elements of electronic circuitry;

FIG. 5 is a top view illustrating a plurality of conductive bumps positioned in a predetermined pattern on a substrate;

FIG. 6 is a bottom view illustrating a typical arrangement of leads of beam tape;

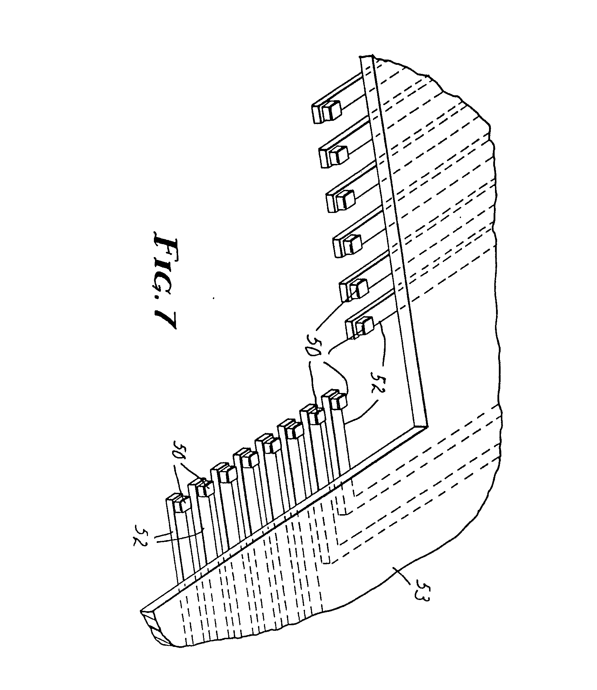

FIG. 7 is an enlarged perspective view of a section of the beam tape of FIG. 6, but with conductive bumps bonded to the leads thereof.

## Detailed Description

In the practice of the methods of the present invention, conductive bumps are preferably formed in a predetermined pattern on a substrate such that electronic circuitry may be aligned over the substrate in a manner which brings the conductive elements of that circuitry into contact with the conductive bumps. This permits gang bonding of the conductive bumps to the conductive elements of the electronic circuitry.

Thus, in FIGS. 1A-1E there is illustrated a preferred additive metallization method for forming conductive bumps which are to be bonded to the conductive elements of electronic circuitry. In FIG. 1A there is illustrated a laminate 10 comprising a substrate 11 (here illustrated as a plastic film), a conductive metallic layer 12 which has been deposited onto the substrate 11, and an overlaying photoresist layer 13 which has been photo-exposed and developed to yield soluble areas corresponding to areas where conductive bumps are to ultimately be formed. The soluble areas of photoresist layer 13 should be of a size, in terms of area, and a shape (e.g. circular, square, etc.) corresponding to that desired for the conductive bumps.

One particularly suitable plastic film for substrate 11 is 50-micrometer "Kapton H-Film" (a polyimide film available from E.I. duPont deNemours Co.). Other suitable materials for substrate 11 include metals and glass.

Suitable conductive metals for preparing metallic layer 12 include those which can be vacuum vapor deposited (e.g. by means of evaporation or sputtering) or which can be deposited by means of electroplating or electroless plating. Examples of suitable metals are gold, copper, solder, tin and aluminum. It is preferred, in order to avoid introduction of undesired metallization, that metallic layer 12 comprise the same type of metal as that which will be employed in the additive metallization technique to form the conductive bumps.

A suitable photoresist for photoresist layer 13 is "AZ-111" (a positive photoresist available from Shipley Co., Inc.)

In FIG. 1B the soluble areas of photoresist layer 13 have been removed by means of a suitable developer to expose conductive metallic layer 12 in areas 14 where the conductive bumps will be formed. As is well-known in the art a suitable developer is one which is compatible with the particular photoresist employed. A suitable developer for use with the aforementioned "AZ-111" photoresist is "AZ-303" (also available from Shipley Co., Inc.).

Referring now to FIG. 1C, conductive bumps 15 are plated to the desired height by any of the additive metallization methods which are well-known in the art. For example, a preferred method for plating gold bumps is well-known in the art and involves immersing the substrate into a plating solution which will deposit high purity, soft gold. A suitable plating solution for plating gold is "Pur-A-Gold 401" (available from Sel-Rex Corp.). In order to reduce the time required for the plating process, it is also preferred that a high agitation rate be employed within the plating cell.

In order to assure good electrical connection during the plating process, it is often desirable to apply conductive silver paint to metallic layer 12 at the area in which electrical connection is made to metallic layer 12.

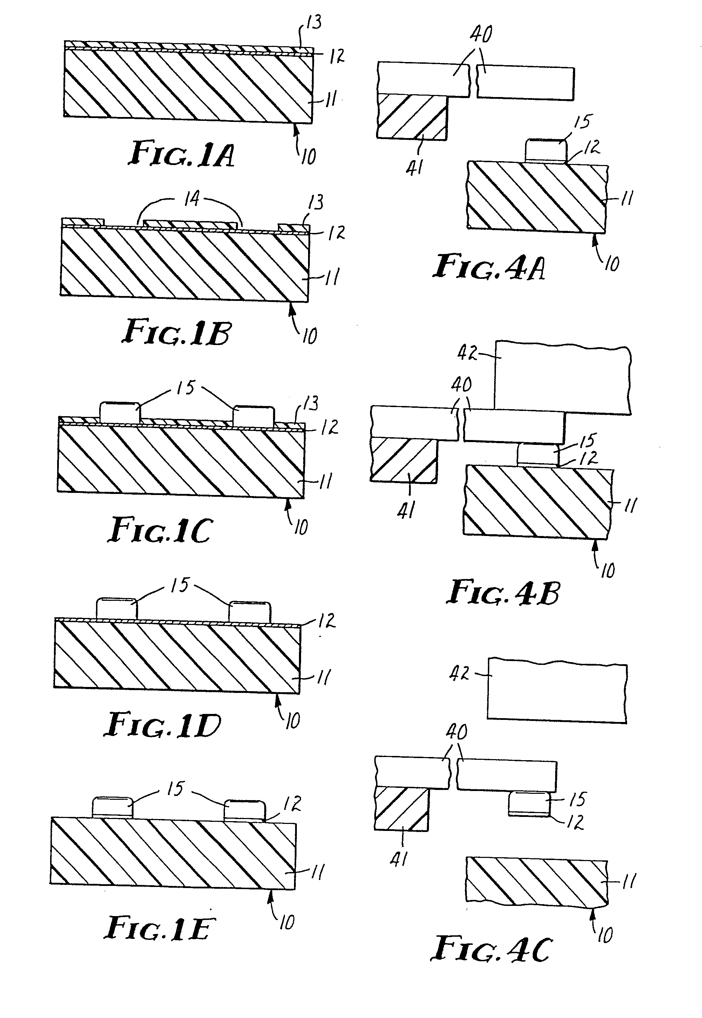

As is illustrated in FIG. 1D, the remainder of photoresist layer 13 is then removed from laminate 10 (e.g., by means of acetone), followed by removal of the conductive metallic layer 12 except in areas underlying conductive bumps 15 as best illustrated in FIG. 1E. When metallic layer 12 comprises gold, a suitable etchant for removing that layer is a conventional potassium iodide-iodine solution. The conductive bumps 15 are now ready for bonding to the conductive elements of electronic circuitry by the bonding means discussed hereinbelow.

FIGS. 2A-2E illustrate a method for forming conductive bumps which is analogous to that illustrated in FIGS. 1A-1E except that here laminate 20 comprises a substrate 21 (here illustrated as glass) having cavities 22 in its surface. As with the laminate illustrated in FIG. 1A, laminate 20 shown in FIG. 2A also comprises a conductive metallic layer, here numbered 23, and a photoresist layer, here numbered 24, with those layers conforming to the contours of the cavities 22. Employment of a substrate 21 having cavities 22 permits formation of conductive bumps having contoured bonding surfaces (e.g., convex surfaces). In some situations, it may be desirable to have bumps exhibiting contoured bonding surfaces in order to facilitate packaging of beam tape and semiconductor devices at lower bonding pressures.

Suitable substrates 21 having cavities 22 may be fabricated from glass, stainless steel and the like using conventional photo-imaging and etching techniques or conventional mechanical milling techniques.

In FIG. 2B, the soluble areas of photoresist layer 24 have been removed to expose metallic layer 23 in the area of the cavities 22 and conductive bumps 25 are then plated to the desired height in the cavities 22 as best illustrated in FIG. 2C. The remainder of photoresist layer 24 and the portion of conductive metallic layer 23 surrounding, but not underlaying, conductive bumps 25 are removed as illustrated in FIGS. 2D and 2E, respectively.

FIGS. 3A-3D illustrate a subtractive metallization method which is particularly useful for fabricating conductive bumps comprising metals which are not easily plated (e.g. aluminum). Thus, in FIG. 3A there is illustrated a laminate 30 comprising a substrate 31, a conductive metallic layer 32 which is adhered to substrate 31 by means of adhesive layer 33 and which is of a thickness corresponding to the height desired for the conductive bumps, and a photoresist layer 34 which has been photo-exposed and developed to leave insoluble regions in areas where conductive bumps are to be formed. The size and shape of those insoluble regions should correspond to that desired for the conductive bumps.

In FIG. 3B, the soluble areas of photoresist layer 34 have been removed by means of a suitable developer such that only the insoluble regions 35 of the photoresist layer 34 remain on laminate 30.

As is illustrated in FIG. 3C, conductive metallic layer 32 has been removed by means of a suitable etchant in all areas except under the insoluble regions 35 of the original photoresist layer 34 to give conductive bumps 36.

In FIG. 3D, the photoresist has been removed and the conductive bumps 36 are now ready for bonding to the conductive elements of electronic circuitry.

Since the conductive bumps of the present invention are not formed in place on the conductive elements of electronic circuitry, a variety of metals may be employed in forming the conductive bumps, with the only limitation being that the metal chosen for a given conductive bump should be compatible with the metallizations of the conductive elements to which the conductive bump will ultimately be bonded. Thus, the methods of the present invention provide for much flexibility in the combinations of metallization which may be employed in packaging technology. For example, conductive bumps comprising gold may be bonded to conductive elements comprising copper, tin-plated copper, or gold-plated copper.

While conductive bumps useful in the methods of the present invention may be of any dimension, preferred conductive bumps will be about 25 to 250 micrometers in diameter and about 25 to 125 micrometers in thickness.

The conductive bumps of the present invention may be bonded to the conductive elements of electronic circuitry by any of the bonding means which are well-known in the art. For example, thermo-compression, ultrasonic, thermosonic and reflow means may all be employed in the practice of the present invention. To bond conductive bumps to conductive elements of electronic circuitry, an appropriate bonding tool (e.g. a thermode) is simply brought into contact with a conductive bump already positioned at the desired location on the conductive element to which it is to be bonded.

When bonding conductive bumps to electronic circuitry having a plurality of conductive elements, it is preferred, as has already been mentioned, that the conductive bumps be formed on a substrate in a predetermined pattern so that the conductive elements of the electronic circuitry contact the conductive bumps as the circuitry is aligned adjacent the substrate. When the conductive bumps are formed in the desired position in this manner, gang bonding, which is a preferred means for bonding the conductive bumps to the conductive elements of electronic circuitry, may then be conveniently employed to simutaneously bond all such conductive bumps to the conductive elements of electronic circuitry in one operation.

Thus, in FIGS. 4A-4C there is illustrated in cross-section the sequential steps involved in the bonding operation of a conductive bump to a lead of beam tape. In FIG. 4A, lead 40, which is attached to dielectric 41, is shown aligned over, but not in contact with, a conductive bump 15 which has been formed on substrate 11 in accordance with the method illustrated in FIGS. 1A-1E. As is illustrated in FIG. 4B, as lead 40 is brought into contact with conductive bump 15, bonding tool 42 (e.g. the thermode of a Jade Corporation thermo-compression gang bonder) is in turn brought into contact with lead 40 opposite conductive bump 15. At this point, bonding of conductive bump 15 to lead 40 will result upon activation of the bonding tool 42. After bonding has been accomplished, bonding tool 42 is retracted and lead 40 to which conductive bump 15 is now bonded is separated from substrate 11 as illustrated in FIG. 4C.

FIG. 5 illustrates an array of conductive bumps 50 positioned in a predetermined pattern on substrate 51, that predetermined pattern corresponding to the positioning of the leads 52 of the section of beam tape 53 illustrated in FIG. 6. Prior to the bonding operation, beam tape 53 is simply aligned adjacent substrate 51 so as to bring each of leads 52 into contact with one of the conductive bumps 50. The bonding tool (not illustrated here) of a gang bonder is then placed over the leads 52 opposite conductive bumps 50 and, once activated, results in bonding of the conductive bumps 50 to the leads 52 of beam tape 53 such as illustrated in FIG. 7.

The methods of the present invention may similarly be employed to conveniently provide the contact pads of semiconductor devices with conductive bumps.

CLAIMS:

1. A method for bonding a plurality of conductive bumps to conductive elements of electronic circuitry, the method comprising the steps of:

(a) providing a substrate having thereon a plurality of conductive bumps arranged in a predetermined pattern,

(b) aligning said electronic circuitry adjacent said substrate such that said conductive elements of said electronic circuitry contact said conductive bumps,

(c) bonding said conductive bumps to said conductive elements of said electronic circuitry, and

(d) separating said electronic circuitry having said conductive bumps bonded thereto from said substrate.

2. A method in accordance with Claim 1, wherein said electronic circuitry comprises beam tape.

3. A method in accordance with Claim 1, wherein said electronic circuitry comprises a semiconductor device.

4. A method in accordance with Claim 1, wherein said bonding of said conductive bumps to said conductive elements is by means of gang bonding.

5. A method in accordance with Claim 1, wherein said conductive bumps and said conductive elements comprise different metals.

6. A method in accordance with Claim 1, wherein said conductive bumps comprise gold and said conductive elements comprise copper.

7. A method in accordance with Claim 1, wherein said conductive bumps comprise gold and said conductive elements comprise tin-plated copper.

8. A method in accordance with Claim 1, wherein said conductive bumps comprise gold and said conductive elements comprise gold-plated copper.

FIG.1A

FIG.1B

FIG.1C

FIG.1D

FIG.1E

FIG.4A

FIG.4B

FIG.4C

FIG.3A

FIG.2A

FIG.3B

FIG.2B

FIG.3C

FIG.2C

FIG.3D

FIG.2D

FIG.2E

FIG.6

FIG.5

FIG. 7